(19) Europäisches Patentamt
European Patent Office
Office européen des brevets

(11) **EP 3 317 967 B1**

(12) **EUROPÄISCHE PATENTSCHRIFT**

(45) Veröffentlichungstag und Bekanntmachung des Hinweises auf die Patenterteilung:
**22.04.2020 Patentblatt 2020/17**

(21) Anmeldenummer: **16733537.1**

(22) Anmeldetag: **30.06.2016**

(51) Int Cl.:
**H03K 17/687** (2006.01)   **H03K 17/0812** (2006.01)
**H03K 17/06** (2006.01)

(86) Internationale Anmeldenummer:
**PCT/EP2016/065230**

(87) Internationale Veröffentlichungsnummer:
**WO 2017/001535 (05.01.2017 Gazette 2017/01)**

(54) **SCHALTUNGSANORDNUNG ZUR ANSTEUERUNG EINES TRANSISTORS**

CIRCUIT ASSEMBLY FOR DRIVING A TRANSISTOR

CIRCUIT DE COMMUTATION DESTINÉ À LA COMMANDE D'UN TRANSISTOR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.06.2015 EP 15174575**

(43) Veröffentlichungstag der Anmeldung:
**09.05.2018 Patentblatt 2018/19**

(73) Patentinhaber: **Fronius International GmbH 4643 Pettenbach (AT)**

(72) Erfinder: **ARTELSMAIR, Bernhard 4643 Pettenbach (AT)**

(74) Vertreter: **Sonn & Partner Patentanwälte Riemergasse 14 1010 Wien (AT)**

(56) Entgegenhaltungen:
**DE-A1-102009 006 618   US-A1- 2011 221 480 US-B1- 6 208 535**

- **NITHIPHAT TEERAKAWANICH ET AL: "A new resonant gate driver with bipolar gate voltage and gate energy recovery", APPLIED POWER ELECTRONICS CONFERENCE AND EXPOSITION (APEC), 2013 TWENTY-EIGHTH ANNUAL IEEE, IEEE, 17. März 2013 (2013-03-17), Seiten 2424-2428, XP032410670, DOI: 10.1109/APEC.2013.6520635 ISBN: 978-1-4673-4354-1**
- **BERGH T ET AL: "A resonant galvanically separated power MOSFET/IGBT gate driver", POWER ELECTRONICS SPECIALISTS CONFERENCE, 2004. PESC 04. 2004 IEEE 35TH ANNUAL, AACHEN, GERMANY 20-25 JUNE 2004, PISCATAWAY, NJ, USA,IEEE, US, 20. Juni 2004 (2004-06-20), Seiten 4243-4247, XP010739422, ISBN: 978-0-7803-8399-9**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine Schaltungsanordnung zur Ansteuerung eines Transistors mit isoliertem Gate, insbesondere eines IGBTs, eines MOSFETs oder eines GaN FETs oder eines SiC FETs, mit einem Gate-Treiber zur Erzeugung eines Treibersignals zwischen einem Pluspol und einem Minuspol mit einer ersten Treiberspannung zum Einschalten des Transistors während einer Einschaltphase und einer zweiten Treiberspannung zum Ausschalten des Transistors während einer Ausschaltphase, und mit einer Kapazität parallel zur Gate-Source-Strecke des Transistors, wobei der Gate-Treiber derart ausgebildet ist, dass das Treibersignal größer oder gleich 0 V ist, eine Induktivität zur Bildung eines Schwingkreises mit der Kapazität vorgesehen ist, welcher Schwingkreis beim Ausschalten des Transistors mit der Änderung des Treibersignals auf die zweite Treiberspannung zum Umladen der Kapazität auf eine unterhalb der zweiten Treiberspannung liegende negative Gate-Source-Spannung ausgebildet ist, und ein Schaltelement im Schwingkreis vorgesehen ist, welches Schaltelement zum Unterbrechen des Schwingkreises nach dem Umladen der Kapazität ausgebildet ist.

Bekannt sind Gate-Treiber zum Einschalten und Ausschalten eines Transistors mit isoliertem Gate einer leistungselektronischen Schaltung. Der Transistor kann beispielsweise durch einen IGBT, MOSFET, GaN FET oder SiC FET gebildet werden. Beispielsweise sind einfache Gate-Treiber dazu ausgebildet, eine erste Treiberspannung zum Einschalten des Transistors und eine zweite Treiberspannung zum Ausschalten des Transistors zu generieren. Zum sicheren Ausschalten und Sperren des Transistors kann es notwendig sein, das Gate des Transistors auf eine negative Gatespannung (für einen n-Kanal Typ eines Transistors) zu laden. Anderenfalls können schon geringe Spannungsschwankungen oder Einstreuungen zu einem unerwünschten Einschalten des Transistors führen, was je nach Verwendung der leistungselektronischen Schaltung auch einen Kurzschluss bedeuten kann. Zum sicheren Ausschalten und Sperren wird daher üblicherweise eine negative Treiberspannung an eine Kapazität am Gate des Transistors angelegt. Eine gängige Methode ist beispielsweise die Versorgung eines Gate-Treibers mit einer negativen Spannung. Dies ist aber aufgrund des mit der Generierung der negativen Spannungsversorgung verbundenen Aufwands nicht vorteilhaft.

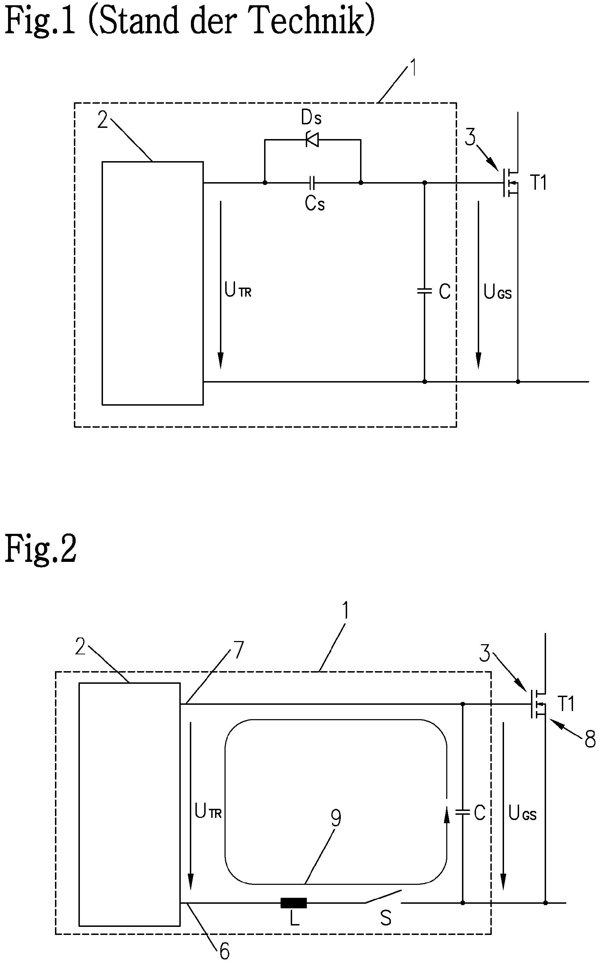

Um den Aufwand der negativen Spannungsversorgung, insbesondere Spannungsversorgungen bei Brückenschaltung von Transistoren einer leistungselektronischen Schaltung, zu vermeiden, werden teilweise auch Schaltungsanordnungen 1 nach Fig. 1 eingesetzt. Dabei wird zwischen Gate-Treiber 2 und Gate 3 des Transistors T1 eine Kapazität $C_S$ parallel zu einer Z-Diode $D_S$ angeordnet. Während der Einschaltphase des Transistors T1 wird $C_S$ auf ein Spannungspotential aufgeladen, das während der Ausschaltphase als negative Spannung zur Verfügung steht. Da die Kapazität $C_S$ während der Ausschaltphase die Kapazität C parallel zur Gate-Source-Strecke des Transistors T1 auf eine negative Gatespannung $U_{GS}$ laden muss, muss sie dementsprechend groß dimensioniert werden. Nachteilig führt dies dazu, dass das gewünschte negative Spannungspotential meist erst nach mehreren Schaltzyklen erreicht wird, da die kurzen Einschaltphasen unter Umständen nicht für eine vollständige Ladung der Kapazität $C_S$ ausreichen und so die Kapazität $C_S$ über mehrere Einschaltphasen geladen werden muss. Ein weiterer offensichtlicher Nachteil einer Schaltungsanordnung 1 nach Fig. 1 ist, dass die negative Gatespannung $U_{GS}$ von der positiven Treiberspannung $U_{TR}$ sozusagen abgezweigt wird und daher zum Einschalten des Transistors T1 nicht mehr zur Verfügung steht. Die positive Gatespannung $U_{GS}$ zum Einschalten des Transistors T1 wird dementsprechend kleiner und ein sicheres Einschalten kann unter Umständen nur mit erhöhtem Schaltungsaufwand erreicht werden.

Die US 2011/221480 A1 beschreibt eine Schaltungsanordnung der gegenständlichen Art, wobei für einen Teil der Schaltungsanordnung eine eigene Spannungsversorgung erforderlich ist, was den Aufwand entsprechend erhöht.

Aus dem Artikel von Nithiphat Teerakawanich et al. "A New Resonant Gate Driver with Bipolar Gate Voltage and Gate Energy Recovery" (Applied Power Electronics Conference and exposition (APEC), 2013, 28 annual, IEEE, 17. März 2013, Seiten 2424 bis 2428) ist ein resonanter Gate-Treiber zur Ansteuerung von Transitoren, wie MOSFETs und IGBTs, bekannt geworden, bei dem die in der Gate-Kapazität gespeicherte Energie für den nächsten Schaltzyklus verwendet wird, wodurch eine einfachere und kostengünstigere Schaltungsanordnung erzielbar ist.

Der Erfindung liegt somit die Aufgabe zugrunde, ausgehend vom eingangs geschilderten Stand der Technik, eine Schaltungsanordnung zur Ansteuerung eines Transistors zu schaffen, die ohne negative Versorgungsspannung dennoch den Transistor sicher ein- und ausschalten kann und auch ein sicheres Sperren des Transistors während der Ausschaltphase gewährleistet. Diese Schaltungsanordnung soll darüber hinaus einfach und kostengünstig aufgebaut sein.

Die Erfindung löst die gestellte Aufgabe dadurch, dass der Teil der Schaltungsanordnung zwischen Gate-Treiber und Transistor zur ausschließlichen Spannungsversorgung mit dem Treibersignal des Gate-Treibers ausgebildet ist, und dass das Schaltelement durch einen zusätzlichen Transistor gebildet ist, und parallel zum Schaltelement eine erste Freilaufdiode angeordnet ist, und die Induktivität des Schwingkreises zwischen dem zusätzlichen Transistor und Gate des Transistors angeordnet ist.

Ist mit der Kapazität parallel zur Gate-Source-Strecke des Transistors eine Induktivität verbunden, und der so gebildete Schwingkreis beim Ausschalten des Transistors zum Umladen der Kapazität am Gate des Transistors auf eine negative Gate-Source-Spannung, die unterhalb der zweiten Treiberspannung liegt, ausgebildet, kann ein sicheres Ausschalten des Transistors gewährleistet werden. Durch das Schaltelement im Schwingkreis kann der Schwingkreis aufgetrennt werden, wodurch eine negative Gate-Source-Spannung, die sich während des Umladens einstellt, erhalten bleibt. Die auf die negative Gate-Source-Spannung geladene Kapazität am Gate des Transistors kann sich nämlich aufgrund des geöffneten Schaltelements nicht weiter entladen, wodurch die negative Gate-Source-Spannung weiterhin bestehen bleiben kann. Mit der erfindungsgemäßen Schaltungsanordnung kann beim Wechsel des Treibersignals von der ersten Treiberspannung zur zweiten Treiberspannung zum Ausschalten des Transistors die positiv geladene Kapazität parallel zur Gate-Source-Strecke des Transistors über die Induktivität entladen werden. Die bei diesem Entladevorgang in die Induktivität transferierte Energie kann ein weiteres Umladen der Kapazität am Gate auf eine negative Gate-Source-Spannung bewirken. Mit dem gleichzeitigen Öffnen des Schaltelements kann ein nochmaliger Umladevorgang verhindert werden, wodurch eine negative Gate-Source-Spannung, die unterhalb der zweiten Treiberspannung liegt, erreicht und gehalten wird. Die Schaltungsanordnung kann daher schon beim ersten Ausschalten die Kapazität parallel zur Gate-Source-Strecke des Transistors auf eine negative Spannung laden, wobei dennoch während der Einschaltphase des Transistors die vollständige positive Treiberspannung zum Einschalten des Transistors zur Verfügung stehen kann. Zudem kann die Schaltungsanordnung aufgrund der wenigen und einfachen Bauelemente schaltungstechnisch einfach aufgebaut und kostengünstig hergestellt werden. Dadurch, dass der Teil der Schaltungsanordnung zwischen Gate-Treiber und Transistor zur ausschließlichen Spannungsversorgung mit dem Treibersignal des Gate-Treibers ausgebildet ist, kann auf eine zusätzliche Spannungsversorgung verzichtet werden, was eine Verringerung der Komplexität der gesamten Schaltungsanordnung und somit auch der Kosten bewirkt. Durch die parallel zum Schaltelement angeordnete erste Freilaufdiode kann der beim Ausschalten des Transistors notwendige Stromfluss zum effektiven Umladen der Kapazität parallel zur Gate-Source-Strecke des Transistors am Schaltelement auf einfache Weise vorbeigeleitet werden. Die Schaltungsanordnung kann vereinfacht werden, wenn die erste Freilaufdiode durch die im zusätzlichen Transistor integrierte Freilaufdiode gebildet ist.

Im Allgemeinen wird festgehalten, dass sich diese Schaltungsanordnung besonders zur Ansteuerung von Transistoren leistungselektronischer Schaltungen mit sich regelmäßig wiederholenden Schaltvorgängen, wie bei Brückenschaltungen, eignet. In diesem Zusammenhang wird mit Ausschaltphase die Dauer bis zum wiederholten Einschalten des selben Transistors verstanden. Diese kann beispielsweise im Bereich weniger μs bis einiger 100 ms liegen.

Bleibt die Gate-Source-Spannung während der gesamten Ausschaltphase negativ, kann nicht nur ein sicheres Ausschalten des Transistors gewährleistet werden, sondern auch ein ungewolltes Wiedereinschalten des Transistors während der Ausschaltphase verhindert werden.

Vorteilhaft auszeichnen kann sich die Schaltungsanordnung, wenn die Gate-Source-Spannung während der Einschaltphase im Wesentlichen der ersten Treiberspannung entspricht. So kann die gesamte erste Treiberspannung zum Einschalten bzw. zum Laden der Kapazität parallel zur Gate-Source-Strecke des Transistors genutzt werden.

Besonders einfache Gate-Treiber können zum Einsatz kommen, wenn die zweite Treiberspannung 0 V beträgt.

Vorteilhafterweise schaltet das Schaltelement bei der ersten Treiberspannung des Treibersignals ein und bei der zweiten Treiberspannung des Treibersignals aus. Dadurch kann die Schaltungsanordnung einfach realisiert werden, da zum Schalten des Schaltelements kein zusätzliches Signal notwendig ist. Auf aufwendige bzw. komplexe Schaltkreise kann somit verzichtet werden.

Durch besondere schaltungstechnische Einfachheit kann die Schaltungsanordnung überzeugen, wenn das Schaltelement durch einen p-Kanal-Feldeffekttransistor oder PNP-Transistor gebildet ist. Dies kann eine Anordnung des zusätzlichen Transistors zwischen Induktivität und Treibersignal sowie eine Ansteuerung des zusätzlichen Transistors ohne zusätzliche Bauelemente erlauben.

Weiter verbessert werden kann die Schaltungsanordnung, wenn der Gate- bzw. Basisanschluss des zusätzlichen Transistors über einen ersten Widerstand mit dem Minuspol des Gate-Treibers verbunden ist und der Source- bzw. Emitteranschluss des zusätzlichen Transistors mit dem Pluspol des Gate-Treibers verbunden ist. Dies kann eine Begrenzung des Basisstroms bzw. des Gateladestroms erlauben, wodurch eine Beschädigung des zusätzlichen Transistors verhindert werden kann.

Ist zwischen Induktivität und Gate des Transistors ein zweiter Widerstand angeordnet, kann mithilfe dieses Widerstands die Dämpfung des Schwingkreises festgelegt werden. Dies kann einen ausreichend raschen Ladevorgang der Kapazität parallel zur Gate-Source-Strecke des Transistors ohne bzw. mit geringem Überschwingen erlauben.

Die Schaltungsanordnung kann weiter verbessert werden, wenn parallel zum zweiten Widerstand ein dritter Widerstand in Serie mit einer zweiten Freilaufdiode angeordnet ist. Dies kann eine unterschiedliche Dämpfung für den Schwingkreis beim Einschalten bzw. Ausschalten des Transistors erlauben, wodurch die Gate-Source-Spannung mit jeweils geringem Überschwingen auf das gewünschte Potential zum Ein- bzw. Ausschalten des Transistors geladen werden kann.

Die Schaltungsanordnung kann bei geeigneter Dimensionierung der einzelnen Bauelemente weiter vereinfacht werden, wenn die Kapazität durch die Gate-Source-Kapazität des Transistors gebildet ist. Auf eine zusätzliche Kapazität zwischen Gate und Source des Transistors kann so verzichtet werden.

Ist parallel zur Kapazität ein vierter Widerstand angeordnet, kann die Gate-Source-Spannung bei fehlender Spannungsversorgung des Gate-Treibers dennoch definiert und so ein "floaten" der Gate-Source-Spannung vermieden werden.

Ein Schutz des Gates des Transistors vor zu hohen positiven oder negativen Spannungen kann erreicht werden, wenn parallel zur Kapazität zwei gegengleich in Serie geschaltete Z-Dioden angeordnet sind. Zudem kann mit diesen Z-Dioden ein Überschwingen der Gate-Source-Spannung während des Einschaltvorgangs des Transistors begrenzt werden.

Die gegenständliche Erfindung wird nachfolgend unter Bezugnahme auf die Figuren näher erläutert, die beispielhaft, schematisch und nicht einschränkend vorteilhafte Ausgestaltungen der Erfindung zeigen. Dabei zeigen:

Fig. 1    eine Schaltungsanordnung zur Ansteuerung eines Transistors nach dem Stand der Technik,

Fig. 2    eine Prinzipskizze einer erfindungsgemäßen Schaltungsanordnung zur Ansteuerung eines Transistors,

Fig. 3    eine konkrete Ausgestaltung einer erfindungsgemäßen Schaltungsanordnung; und

Fig. 4    die Spannungsverläufe der Schaltungsanordnung nach Fig. 3 des Gate-Treibers und an der Kapazität parallel zur Gate-Source-Strecke des Transistors.

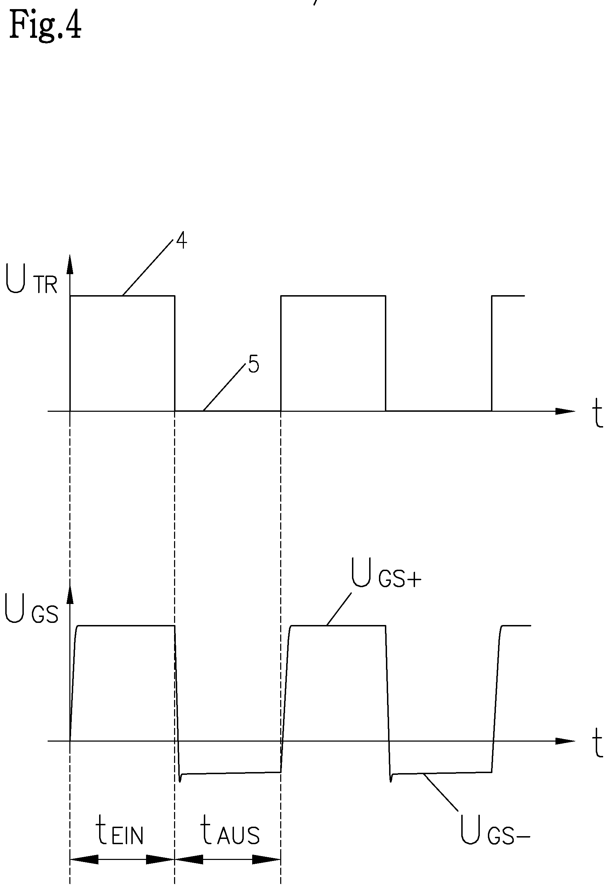

In Fig. 2 wird eine Prinzipskizze einer Schaltungsanordnung 1 zur Ansteuerung eines Transistors T1 mit isoliertem Gate 3, insbesondere eines IGBTs, eines MOSFETs oder eines GaN FETs oder eines SiC FETs mit einem Gate-Treiber 2 zur Erzeugung eines Treibersignals $U_{TR}$ zwischen einem Pluspol 7 und einem Minuspol 6 gezeigt. Zur Ansteuerung des Transistors T1 gibt der Gate-Treiber 2 ein Treibersignal $U_{TR}$ aus, welches größer oder gleich Null Volt beträgt, um eine Kapazität C am Gate 3 des Transistors T1 auf eine Gate-Source-Spannung $U_{GS}$ zu laden beziehungsweise zu entladen. Entsprechend Fig. 4 weist das Treibersignal $U_{TR}$ dazu eine erste Treiberspannung 4 zum Einschalten und eine zweite Treiberspannung 5 zum Ausschalten des Transistors T1 auf. Zum sicheren Ausschalten und Sperren des Transistors T1 ist es vorteilhaft, das Gate 3 des Transistors T1 auf eine negative Gate-Source-Spannung $U_{GS}$ zu laden. Anderenfalls könnten schon geringe Spannungsschwankungen oder Einstreuungen zu einem unerwünschten Einschalten oder kurzzeitigem Durchschalten des Transistors T1 führen, was je nach Verwendung der leistungselektronischen Schaltung (nicht dargestellt) auch einen Kurzschluss bedeuten kann.

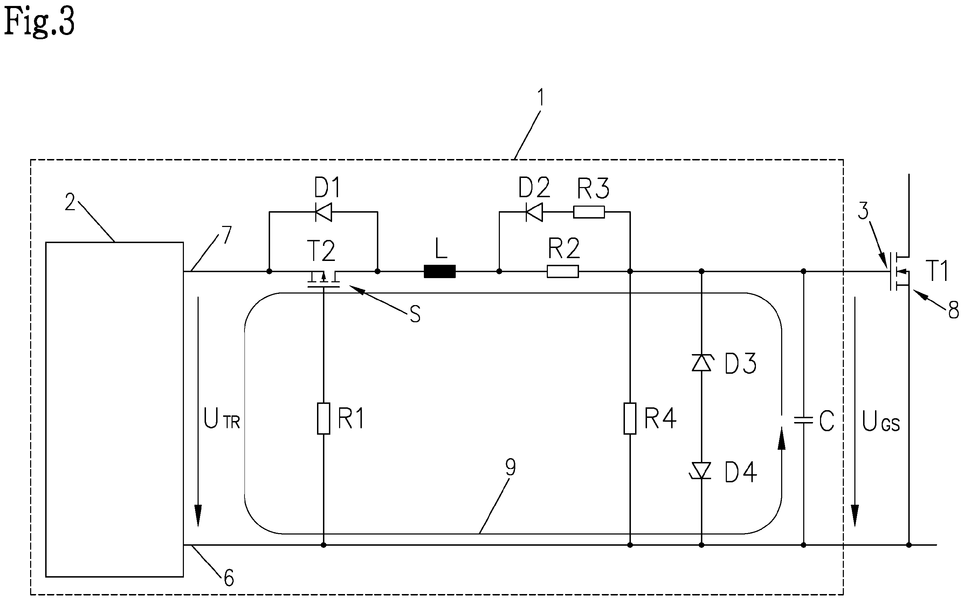

Daher ist erfindungsgemäß mit der Kapazität C parallel zur Gate 3-Source 8-Strecke des Transistors T1 eine Induktivität L verbunden, die mit der Kapazität C des Transistors T1 einen Schwingkreis 9 bildet. Durch entsprechende Dimensionierung der Bauelemente ist dieser Schwingkreis 9 beim Ausschalten des Transistors T1 zum Umladen der Kapazität C parallel zur Gate 3-Source 8-Strecke des Transistors T1, auf eine negative Gate-Source-Spannung $U_{GS}$, die unterhalb der zweiten Treiberspannung 5 liegt, ausgebildet. Mit dem Umschalten des Gate-Treibers 2 von der ersten 4 auf die zweite Treiberspannung 5 entlädt sich die in der Kapazität C gespeicherte Energie, was einen Stromfluss durch die Induktivität L bewirkt. Auch wenn die Kapazität C entladen ist, bleibt dieser Stromfluss aufrecht, da sprunghafte Stromänderungen durch die Induktivität L verhindert werden. Die in der Induktivität L vorhandene magnetische Energie bewirkt so eine weitere Entladung bzw. Umladung der Kapazität C auf eine negative Gate-Source-Spannung $U_{GS}$, die unterhalb der zweiten Treiberspannung 5 liegt. Zudem ist ein Schaltelement S im Schwingkreis 9 angeordnet, das erlaubt, den Schwingkreis 9 aufzutrennen. Durch den aufgetrennten Schwingkreis 9 wird ein neuerliches Umladen der Kapazität C verhindert, sodass die negative Gate-Source-Spannung $U_{GS}$ erhalten bleibt. Diese negative Gate-Source-Spannung $U_{GS}$ gewährleistet in der gezeigten Schaltungsanordnung 1 das sichere Ausschalten und Sperren des Transistors T1. Unerwünschtes Einschalten bzw. kurzzeitiges Durchschalten des Transistors T1, welches eventuell durch geringe Spannungsschwankungen oder Einstreuungen verursacht werden könnte, wird so effektiv verhindert. Besonders vorteilhaft lädt die Schaltungsanordnung 1 schon beim ersten Ausschalten die Kapazität C am Gate 3 des Transistors T1 auf eine negative Spannung. Dennoch steht während der Einschaltphase $t_{EIN}$ des Transistors T1 die vollständige positive erste Treiberspannung 4 zum Einschalten des Transistors T1 zur Verfügung. Zudem ist diese Schaltungsanordnung 1 aufgrund der wenigen und einfachen Bauelemente schaltungstechnisch einfach aufgebaut und kostengünstig herstellbar. In den gezeigten Beispielen nach Fig. 2 und 3 handelt es sich beim Transistor T1 um einen selbstsperrenden nKanal FET. Ein Einsatz für andere Transistortypen ist bei entsprechender Abwandlung der Schaltungsanordnung 1 natürlich denkbar.

Im Allgemeinen wird festgehalten, dass die Induktivität L nicht unbedingt durch ein diskretes Bauelement ausgebildet sein muss, sondern auch durch eine Leitung auf einer Schaltungsplatine ausgebildet sein kann.

Die gezeigte Schaltungsanordnung 1 eignet sich auch zur Ansteuerung von Transistoren T1 leistungselektronischer Schaltungen mit sich regelmäßig wiederholenden Schaltvorgängen, wie bei Brückenschaltungen. Abhängig von der Schaltfrequenz beträgt die Ausschaltphase $t_{AUS}$ des Transistors, T1, wenige $\mu$s bis einige 100 ms. Bei geeigneter Dimensionierung des Schwingkreises 9, also von Induktivität L, Kapazität C und eventuell vorhandenen Widerständen, bleibt die Gate-Source-Spannung $U_{GS}$ während dieser gesamten Ausschaltphase $t_{AUS}$ negativ. So wird nicht nur ein sicheres Ausschalten des Transistors T1 gewährleistet, sondern auch ein ungewolltes Wiedereinschalten des Transistors T1 während der Ausschaltphase $t_{AUS}$ verhindert.

Wie aus der konkreten Ausführungsform gemäß Fig. 3 ersichtlich, entspricht die Gate-Source-Spannung $U_{GS}$ während der Einschaltphase $t_{EIN}$ im Wesentlichen der ersten Treiberspannung 4. Somit steht die gesamte Spannung der ersten Treiberspannung 4 zum Einschalten bzw. zum Laden der Kapazität C parallel zur Gate 3-Source 8-Strecke des Transistors T1 zur Verfügung, was schnelle und zuverlässige Schaltvorgänge erlaubt. Die geringfügigen Abweichungen von der ersten Treiberspannung 4 werden durch den Ladevorgang der Kapazität C und eventuellen Verlusten in der Schaltungsanordnung 1 verursacht. Die zweite Treiberspannung 5 ist hingegen 0 V, was für den Gate-Treiber 2 einen besonders einfachen Aufbau und damit den Einsatz kostengünstiger Gate-Treiber 2 ermöglicht.

Zudem ist der Teil der Schaltungsanordnung 1 zwischen Gate-Treiber 2 und Transistor T1, wie aus Fig. 2 und 3 erkennbar, zur ausschließlichen Spannungsversorgung mit dem Treibersignal $U_{TR}$ ausgebildet. Dementsprechend ist nur eine in den Figuren nicht näher dargestellte Spannungsquelle zur Spannungsversorgung des Gate-Treibers 2 erforderlich, um die gesamte Schaltungsanordnung 1 mit elektrischer Energie zu versorgen. Der Gate-Treiber 2 versorgt dann mittels seines Treibersignals $U_{TR}$ den nachfolgenden Teil der Schaltungsanordnung 1 mit elektrischer Energie. Der Verzicht auf eine zusätzliche Spannungsversorgung verringert sowohl die Komplexität der gesamten Schaltungsanordnung sowie auch deren Kosten.

In der Schaltungsanordnung 1 ist parallel zum Schaltelement S eine erste Freilaufdiode D1 angeordnet. Diese erlaubt trotz geöffnetem Schaltelement S den Umladevorgang bis zur Richtungsänderung des Stromflusses weiterzuführen. Diese Richtungsänderung des Stromflusses tritt ein, wenn die in der Induktivität L gespeicherte Energie wieder vollständig abgegeben wurde. Dies entspricht dem gewünschten Ende des Umladevorgangs, da zu diesem Zeitpunkt die Spannung am Kondensator C im Bereich ihres negativen Maximums ist. Der Einsatz der Freilaufdiode D1 erlaubt also, das Schaltelement S zu einem beliebigen Zeitpunkt zwischen Wechsel von der ersten Treiberspannung 4 auf die zweite Treiberspannung 5 und Ende des Umladevorgangs der Kapazität C auf die negative Gate-Source-Spannung $U_{GS}$ zu öffnen. Dies gestattet weitere Vereinfachungen der Schaltungsanordnung 1, da das Treibersignal $U_{TR}$ auch direkt zum Schalten des Schaltelements S verwendet werden kann.

Dementsprechend schaltet das Schaltelement S in der Schaltungsanordnung 1 nach Fig. 3 bei der ersten Treiberspannung 4 des Treibersignals $U_{TR}$ ein und bei der zweiten Treiberspannung 5 des Treibersignals $U_{TR}$ aus. Wie schon oben erwähnt, ist somit kein zusätzliches Signal zum Schalten des Schaltelements S erforderlich, was eine einfach realisierbare Schaltungsanordnung 1 erlaubt.

Die Schaltungsanordnung 1 gemäß Figur 3 ist schaltungstechnisch besonders einfach aufgebaut, da das Schaltelement S durch einen zusätzlichen Transistor T2 gebildet ist. Eine Anordnung des zusätzlichen Transistors T2 zwischen Induktivität L und Treibersignal $U_{TR}$ sowie eine Ansteuerung des zusätzlichen Transistors T2 ohne zusätzliche Bauelemente wird so möglich. Im gezeigten Beispiel ist der zusätzliche Transistor T2 durch einen P-Kanal FET ausgebildet aber auch die Verwendung eines PNP Transistors ist denkbar.

Wie in Fig. 3 gezeigt ist der Gateanschluss des zusätzlichen Transistors T2 über einen ersten Widerstand R1 mit dem Minuspol 6 des Gate-Treibers 2 und der Sourceanschluss mit dem Pluspol 7 des Gate-Treibers 2 verbunden. Dies begrenzt den Gateladestrom des zusätzlichen Transistors T2 und erlaubt zugleich die einfache Ansteuerung eines P-Kanal FETs mit einem geringen Einsatz an Bauelementen. Die Verbindung des Minuspols 6 des Gate-Treibers 2 mit einem Masseanschluss ist vorstellbar, aber nicht unbedingt erforderlich.

Weiters ist vorstellbar, dass keine dezidierte erste Freilaufdiode D1 eingesetzt wird, sondern dass die erste Freilaufdiode D1 durch die im zusätzlichen Transistor T2, insbesondere durch die im P-Kanal FET integrierte Freilaufdiode, ausgebildet ist. Der Bauteilaufwand für die Schaltungsanordnung 1 kann so weiter reduziert werden.

Zwischen Induktivität L und Gate 3 des Transistors T1 kann ein zweiter Widerstand R2 angeordnet sein. Dieser Widerstand R2 bestimmt die Dämpfung des Schwingkreises 9 für den Einschaltvorgang und hat damit Einfluss auf den Ladevorgang der Kapazität C parallel zur Gate-Source-Strecke des Transistors T1. Durch geeignete Bauteildimensionierung wird so ein Überschwingen der Gate-Source-Spannung $U_{GS}$ beim Einschalten des Transistors T1 vermieden.

Parallel zum zweiten Widerstand R2 kann ein dritter Widerstand R3 in Serie mit einer zweiten Freilaufdiode D2 angeordnet sein. Mit diesem dritten Widerstand R3 wird eine unterschiedliche Dämpfung für den Schwingkreis 9 beim Ausschalten des Transistors T1 eingestellt. Eine Verringerung des Überschwingens der Gate-Source-Spannung $U_{GS}$ beim Ausschalten und dem damit verbundenen Umladen der Kapazität C lässt sich damit erreichen. Der Lade- und Entlade- bzw. Umladevorgang ist so getrennt beeinflussbar, was Optimierungen hinsichtlich der Flankensteilheit und des Überschwingens der Gate-Source-Spannung $U_{GS}$ erlaubt.

Weitere Vereinfachungen ergeben sich, wenn die Kapazität C durch die Gate-Source-Kapazität des Transistors T1 gebildet ist. Auf eine zusätzliche Kapazität C zwischen Gate 3 und Source 8 kann so verzichtet werden.

Parallel zur Kapazität C kann ein vierter Widerstand R4 angeordnet sein, um die Gate-Source-Spannung $U_{GS}$ bei fehlender Spannungsversorgung des Gate-Treibers 2 dennoch zu definieren und so ein "floaten" der Gate-Source-Spannung $U_{GS}$ zu vermeiden.

Zum Schutz des Gates 3 des Transistors T1 vor zu hoher positiver oder negativer Gate-Source-Spannung $U_{GS}$ sind parallel zur Kapazität C zwei gegengleich in Serie geschaltete Z-Dioden D3, D4 angeordnet. Zudem wird durch die Z-Dioden D3, D4 ein Überschwingen der Gate-Source-Spannung $U_{GS}$ während des Einschaltvorgangs des Transistors T1 begrenzt. Eine dementsprechend vorteilhafte, steile Anstiegsflanke der Gate-Source-Spannung $U_{GS}$ bei Wechsel von der ersten Treiberspannung 4 zur zweiten Treiberspannung 5 wird dadurch erreicht.

Bei einer beispielhaften Dimensionierung der Bauelemente der Schaltungsanordnung 1 nach Fig. 3 ist eine Flankenabfallzeit der positiven Gate-Source-Spannung $U_{GS}$ auf die negative Gate-Source-Spannung $U_{GS}$ kleiner gleich 100 ns wünschenswert, um die Ausschaltverluste des Transistors T1 klein zu halten. Zugleich soll die Flankensteilheit kleiner als die halbe Periodendauer des Schwingkreises 9 sein, da innerhalb einer halben Periode der Umladevorgang der Kapazität C abgeschlossen wird und ein erneutes Umschwingen durch das Sperrverhalten der Diode D1 unterbunden wird. Beim folgenden Dimensionierungsbeispiel wird eine Periodendauer T = 140 ns (T = $t_{EIN}$ + $t_{AUS}$) angenommen. Bei einer Kapazität C von 5 nF, was etwa einer typischen Gate-Source-Kapazität eines Leistungs-FETs entspricht, und einer Flankenabfallzeit von 70 ns ergibt sich entsprechend der Formel

$$L = \frac{T^2}{4\pi^2 C}$$

eine Induktivität L von etwa 100 nH.

Für die weitere beispielhafte Dimensionierung wird eine positive Gate-Source-Spannung $U_{GS+}$ von 20 V und eine negative Gate-Source-Spannung $U_{GS-}$ von -5V angenommen. Aus der Formel

$$R_{Ges} = -\frac{2L \ln\frac{U_{GS-}}{U_{GS+}}}{t}, \quad \text{mit} \quad t = \frac{T}{2}$$

ergibt sich ein gesamter ohmscher Widerstand, einschließlich aller Verluste, des Schwingkreises von etwa 4 Ohm. Da neben den ohmschen Verlusten von Induktivität und Kapazität auch noch der Gate-Treiber und die Flussspannung der Dioden zu berücksichtigen sind, müssen die einzelnen Widerstände dementsprechend kleiner bzw. der zur Kapazität C parallele Widerstand R4 größer dimensioniert werden. So ergeben sich bei einer beispielhaften Dimensionierung der Widerstände R2 mit 3,3 Ohm, R3 mit 1 Ohm und R4 mit 10 kOhm.

Selbstverständlich können die tatsächlich verwendeten Werte für Induktivität, Kapazität und Widerstände von dem angegebenen Dimensionierungsbeispiel abweichen. Abhängig von den individuellen Anforderungen an die Schaltungsanordnung 1, sowie Transistor T1 und Gate-Treiber 2 sind Dimensionierungen der Bauteile mit obigen beispielhaften Werten um eine Zehner-Potenz nach oben sowie nach unten vorstellbar.

## Patentansprüche

1. Schaltungsanordnung (1) zur Ansteuerung eines Transistors (T1) mit isoliertem Gate (3), mit einem Gate-Treiber (2) zur Erzeugung eines Treibersignals ($U_{TR}$) zwischen einem Pluspol (7) und einem Minuspol (6) mit einer ersten Treiberspannung (4) zum Einschalten des Transistors (T1) während einer Einschaltphase ($t_{EIN}$) und einer zweiten Treiberspannung (5) zum Ausschalten des Transistors (T1) während einer Ausschaltphase ($t_{AUS}$), und mit einer Kapazität (C) parallel zur Gate (3)-Source (8)-Strecke des Transistors (T1), wobei der Gate-Treiber (2) derart ausgebildet ist, dass das Treibersignal ($U_{TR}$) größer oder gleich Null Volt ist, eine Induktivität (L) zur Bildung eines Schwingkreises (9) mit der Kapazität (C) vorgesehen ist, welcher Schwingkreis (9) beim Ausschalten des Transistors (T1) mit der Änderung des Treibersignals ($U_{TR}$) auf die zweite Treiberspannung (5) zum Umladen der Kapazität (C) auf eine unterhalb der zweiten Treiberspannung (5) liegende negative Gate-Source-Spannung ($U_{GS}$) ausgebildet ist, und ein Schaltelement (S) im Schwingkreis (9) vorgesehen ist, welches Schaltelement (S) zum Unterbrechen des Schwingkreises (9) nach dem Umladen der Kapazität (C) ausgebildet ist, wobei der Teil der Schaltungsanordnung (1) zwischen Gate-Treiber (2) und Transistor (T1) zur ausschließlichen Spannungsversorgung mit dem Treibersignal ($U_{TR}$) des Gate-Treibers (2) ausgebildet ist, und dass das Schaltelement (S) durch einen zusätzlichen Transistor (T2) gebildet ist, und parallel zum Schaltelement (S) eine erste Freilaufdiode (D1) angeordnet ist, und dass die Induktivität (L) des Schwingkreises (9) zwischen zusätzlichem Transistor (T2) und Gate (3) des Transistors (T1) angeordnet ist.

2. Schaltungsanordnung (1) nach Anspruch 1, **dadurch gekennzeichnet, dass** die Gate-Source-Spannung ($U_{GS}$) während der gesamten Ausschaltphase ($T_{AUS}$) negativ ist.

3. Schaltungsanordnung (1) nach Anspruch 1 oder 2, **dadurch gekennzeichnet, dass** die Gate-Source-Spannung ($U_{GS}$) während der Einschaltphase ($t_{EIN}$)

im Wesentlichen der ersten Treiberspannung (4) des Gate-Treibers (2) entspricht.

4. Schaltungsanordnung (1) nach einem der Ansprüche 1 bis 3, **dadurch gekennzeichnet, dass** die zweite Treiberspannung (5) des Gate-Treibers (2) 0 V beträgt.

5. Schaltungsanordnung (1) nach einem der Ansprüche 1 bis 4, **dadurch gekennzeichnet, dass** das Schaltelement (S) zum Einschalten bei der ersten Treiberspannung (4) und zum Ausschalten bei der zweiten Treiberspannung (5) ausgebildet ist.

6. Schaltungsanordnung (1) nach einem der Ansprüche 1 bis 5, **dadurch gekennzeichnet, dass** das Schaltelement (S) durch einen p-Kanal-Feldeffekttransistor oder PNP-Transistor gebildet ist.

7. Schaltungsanordnung (1) nach einem der Ansprüche 1 bis 6, **dadurch gekennzeichnet, dass** der Gate- bzw. Basis-Anschluss des zusätzlichen Transistors (T2) über einen ersten Widerstand (R1) mit dem Minuspol (6) des Gate-Treibers (2) verbunden ist und der Source- bzw. Emitter-Anschluss des zusätzlichen Transistors (T2) mit dem Pluspol (7) des Gate-Treibers (2) verbunden ist.

8. Schaltungsanordnung (1) nach einem der Ansprüche 1 bis 7, **dadurch gekennzeichnet, dass** zwischen Induktivität (L) und Gate (3) des Transistors (T1) ein zweiter Widerstand (R2) angeordnet ist.

9. Schaltungsanordnung (1) nach Anspruch 8, **dadurch gekennzeichnet, dass** parallel zum zweiten Widerstand (R2) ein dritter Widerstand (R3) in Serie mit einer zweiten Freilaufdiode (D2) angeordnet ist.

10. Schaltungsanordnung (1) nach einem der Ansprüche 1 bis 9, **dadurch gekennzeichnet, dass** parallel zur Kapazität (C) ein vierter Widerstand (R4) angeordnet ist.

11. Schaltungsanordnung (1) nach einem der Ansprüche 1 bis 10, **dadurch gekennzeichnet, dass** parallel zur Kapazität (C) zwei gegengleich in Serie geschaltete Z-Dioden (D3, D4) angeordnet sind.

**Claims**

1. Circuit arrangement (1) for controlling a transistor (T1) having an insulated gate (3), comprising a gate driver (2) for generating a driver signal ($U_{TR}$) between a positive pole (7) and a negative pole (6), which driver signal has a first driver voltage (4) for switching on the transistor (T1) during a switch-on phase ($t_{EIN}$) and a second driver voltage (5) for switching off the transistor (T1) during a switch-off phase ($t_{AUS}$), and comprising a capacitor (C) parallel to the gate (3)-source (8)-path of the transistor (T1), wherein the gate driver (2) is designed such that the driver signal ($U_{TR}$) is greater than or equal to zero volts, an inductor (L) is provided for forming a resonant circuit (9) with the capacitor (C), which resonant circuit (9) is designed to recharge the capacitor (C) to a negative gate-source voltage ($U_{GS}$) below the second driver voltage (5) when the transistor (T1) is being switched off by changing the driver signal ($U_{TR}$) to the second driver voltage (5), and a switching element (S) is provided in the resonant circuit (9), which switching element (S) is designed to interrupt the resonant circuit (9) after the capacitor (C) has been recharged, wherein the part of the circuit arrangement (1) between the gate driver (2) and transistor (T1) is designed for the exclusive supply of voltage using the driver signal ($U_{TR}$) of the gate driver (2), and the switching element (S) is formed by an additional transistor (T2), and a first freewheeling diode (D1) is arranged in parallel with the switching element (S), and the inductor (L) of the resonant circuit (9) is arranged between the additional transistor (T2) and gate (3) of the transistor (T1).

2. Circuit arrangement (1) according to claim 1, **characterised in that** the gate-source voltage ($U_{GS}$) is negative during the entire switch-off phase ($t_{AUS}$).

3. Circuit arrangement (1) according to either claim 1 or claim 2, **characterised in that** the gate-source voltage ($U_{GS}$) during the switch-on phase ($t_{EIN}$) corresponds substantially to the first driver voltage (4) of the gate driver (2).

4. Circuit arrangement (1) according to any of claims 1 to 3, **characterised in that** the second driver voltage (5) of the gate driver (2) is 0 V.

5. Circuit arrangement (1) according to any of claims 1 to 4, **characterised in that** the switching element (S) is designed for switching on at the first driver voltage (4) and for switching off at the second driver voltage (5).

6. Circuit arrangement (1) according to any of claims 1 to 5, **characterised in that** the switching element (S) is formed by a p-channel field effect transistor or PNP transistor.

7. Circuit arrangement (1) according to any of claims 1 to 6, **characterised in that** the gate or base terminal of the additional transistor (T2) is connected to the negative pole (6) of the gate driver (2) via a first resistor (R1) and the source or emitter terminal of the additional transistor (T2) is connected to the positive pole (7) of the gate driver (2).

8. Circuit arrangement (1) according to any of claims 1 to 7, **characterised in that** a second resistor (R2) is arranged between the inductor (L) and gate (3) of the transistor (T1).

9. Circuit arrangement (1) according to claim 8, **characterised in that** a third resistor (R3) is arranged in series with a second free-wheeling diode (D2) and in parallel with the second resistor (R2).

10. Circuit arrangement (1) according to any of claims 1 to 9, **characterised in that** a fourth resistor (R4) is arranged in parallel with the capacitor (C).

11. Circuit arrangement (1) according to any of claims 1 to 10, **characterised in that** two Z diodes (D3, D4) which are connected in series so as to be diametrically opposed are arranged in parallel with the capacitor (C).

## Revendications

1. Configuration de circuit (1) pour le contrôle d'un transistor (T1) avec une grille (3) isolée, avec un circuit d'attaque de grille (2) pour la génération d'un signal d'attaque ($U_{TR}$) entre un pôle positif (7) et un pôle négatif (6) avec une première tension d'attaque (4) pour l'activation du transistor (T1) pendant une phase d'activation ($t_{EIN}$) et une deuxième tension d'attaque (5) pour la désactivation du transistor (T1) pendant une phase de désactivation ($t_{AUS}$) et avec une capacité (C) parallèle au trajet grille (3) - source (8) du transistor (T1), dans lequel le circuit d'attaque de grille (2) est conçu de façon à ce que le signal d'attaque ($U_{TR}$) est supérieur ou égal à zéro volt, une inductance (L) est prévue pour la formation d'un circuit oscillant (9) avec la capacité (C), ce circuit oscillant (9) étant conçu, lors de la désactivation du transistor (T1) avec la modification du signal d'attaque ($U_{TR}$) vers la deuxième tension d'attaque (5), pour le transfert de charge de la capacité (C) vers une tension grille-source ($U_{GS}$) négative se trouvant en dessous de la deuxième tension d'attaque (5) et un élément de commutation (S) est prévu dans le circuit oscillant (9), cet élément de commutation (S) étant conçu pour interrompre le circuit oscillant (9) après le transfert de charge de la capacité (C), dans lequel la partie de la configuration de circuit (1) entre le circuit d'attaque de grille (2) et le transistor (T1) est conçu pour l'alimentation en tension exclusivement avec le signal d'attaque ($U_{TR}$) du circuit d'attaque de grille (2) et en ce que l'élément de commutation (S) est constitué d'un transistor supplémentaire (T2) et, parallèlement à l'élément de commutation (S), est disposée une diode de roue libre (D1) et en ce que l'inductance (L) du circuit oscillant (9) est disposée entre le transistor supplémentaire (T2) et la grille (3) du transistor (T1).

2. Configuration de circuit (1) selon la revendication 1, **caractérisée en ce que** la tension grille-source ($U_{GS}$) est négative pendant toute la phase de désactivation ($t_{AUS}$).

3. Configuration de circuit (1) selon la revendication 1 ou 2, **caractérisée en ce que** la tension grille-source ($U_{GS}$) correspond, pendant la phase d'activation ($t_{EIN}$), globalement à la première tension d'attaque (4) du circuit d'attaque de la grille (2).

4. Configuration de circuit (1) selon l'une des revendications 1 à 3, **caractérisée en ce que** la deuxième tension d'attaque (5) du circuit d'attaque de grille (2) est de 0 V.

5. Configuration de circuit (1) selon l'une des revendications 1 à 4, **caractérisée en ce que** l'élément de commutation (S) est conçu pour l'activation dans le cas de la première tension d'attaque (4) et pour la désactivation dans le cas de la deuxième tension d'attaque (5).

6. Configuration de circuit (1) selon l'une des revendications 1 à 5, **caractérisée en ce que** l'élément de commutation (S) est constitué d'un transistor à effet de champ à canal p ou d'un transistor PNP.

7. Configuration de circuit (1) selon l'une des revendications 1 à 6, **caractérisé en ce que** la borne de grille resp. de base du transistor supplémentaire (T2) est reliée, par l'intermédiaire d'une première résistance (R1), avec le pôle négatif (6) du circuit d'attaque de grille (2) et la borne de source resp. d'émetteur du transistor supplémentaire (T2) est reliée avec le pôle positif (7) du circuit d'attaque de grille (2).

8. Configuration de circuit (1) selon l'une des revendications 1 à 7, **caractérisée en ce que**, entre l'inductance (L) et la grille (3) du transistor (T1), est disposée une deuxième résistance (R2).

9. Configuration de circuit (1) selon la revendication 8, **caractérisée en ce que**, parallèlement à la deuxième résistance (R2), est disposée une troisième résistance (R3) en série avec une deuxième diode de roue libre (D2).

10. Configuration de circuit (1) selon l'une des revendications 1 à 9, **caractérisée en ce que**, parallèlement à la capacité (C), est disposée une quatrième résistance (R4).

11. Configuration de circuit (1) selon l'une des revendications 1 à 10, **caractérisée en ce que**, parallèlement à la capacité (C), sont disposées deux diodes Z (D3, D4) branchées en série de manière opposée.

# Fig.1 (Stand der Technik)

# Fig.2

Fig.3

EP 3 317 967 B1

# Fig.4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2011221480 A1

**In der Beschreibung aufgeführte Nicht-Patentliteratur**

- A New Resonant Gate Driver with Bipolar Gate Voltage and Gate Energy Recovery. **VON NITHIPHAT TEERAKAWANICH et al.** Applied Power Electronics Conference and exposition (APEC), 2013, 28 annual. IEEE, 17. Marz 2013, 2424-2428